# EUROPÄISCHE PATENTSCHRIFT

(11) **EP 3 803 711 B1**
(45) Veröffentlichungstag und Bekanntmachung des Hinweises auf die Patenterteilung: **25.02.2026**
(21) Anmeldenummer: 19739939.7
(22) Anmeldetag: 02.07.2019
(51) Int. Cl.: G06N 3/045, G06N 3/0495, G06N 3/0499, G06N 3/082, G06N 3/09

(54) **ENTWURF UND HERSTELLUNG EINER STRÖMUNGSMASCHINENSCHAUFEL**
DESIGN AND PRODUCTION OF A TURBOMACHINE VANE
CONCEPTION ET FABRICATION D'UNE AUBE DE TURBOMACHINE

(30) Priorität: 03.07.2018 DE 102018210894
(43) Veröffentlichungstag der Anmeldung: 14.04.2021
(73) Patentinhaber: Siemens Energy Global GmbH & Co. KG, 81739 München (DE)
(72) Erfinder: HEIN, Daniel, 81549 München (DE); KUNTZE-FECHNER, Felix, 47799 Krefeld (DE); PEEREN, Christian, 10245 Berlin (DE); STERZING, Volkmar, 85579 Neubiberg (DE)
(86) Internationale Anmeldenummer: PCT/EP2019/067706
(87) Internationale Veröffentlichungsnummer: WO 2020/007844

(56) Entgegenhaltungen:
- US-A1- 2003 163 436
- JOSE M SANZ: "A Neural Network Aero Design System for Advanced Turbo-Engines", 1 January 1999 (1999-01-01), XP055628340, Retrieved from the Internet <URL:https://ntrs.nasa.gov/archive/nasa/casi.ntrs.nasa.gov/20000012455.pdf>
- DONGYUN LU ET AL: "Neural network based torque control of switched reluctance motor for hybrid electric vehicle propulsion at low speeds", ELECTRO/INFORMATION TECHNOLOGY, 2009. EIT '09. IEEE INTERNATIONAL CONFERENCE ON, IEEE, PISCATAWAY, NJ, USA, 7 June 2009 (2009-06-07), pages 417 - 422, XP031499388, ISBN: 978-1-4244-3354-4
- JUYONG KIM ET AL: "SplitNet: Learning to Semantically Split Deep Networks for Parameter Reduction and Model Parallelization", 1 January 2017 (2017-01-01), XP055534564, Retrieved from the Internet <URL:http://proceedings.mlr.press/v70/kim17b/kim17b.pdf> [retrieved on 20181214]

## Beschreibung

Die Erfindung betrifft ein Verfahren zum Entwerfen einer Strömungsmaschinenschaufel. Des Weiteren betrifft die Erfindung ein Verfahren zum Herstellen einer Strömungsmaschinenschaufel. Ferner betrifft die Erfindung eine Rechnereinheit sowie ein maschinenlesbares Speichermedium.

Das Entwerfen einer Strömungsmaschinenschaufel ist ein komplexer Prozess. Dies ist unter anderem darauf zurückführbar, dass einerseits für die Charakterisierung einer Strömungsmaschinenschaufel typischerweise ein Mehrzahl von Schaufelparametern benötigt wird und die zu entwerfende Strömungsmaschinenschaufel unterschiedlichen Randbedingungen (insbesondere aus verschiedenen Fachdisziplinen, wie Fluiddynamik, Festigkeit, Wärmetechnik etc.) genügen soll und andererseits oftmals nur geringes explizites Wissen über die meist komplexen Zusammenhänge/Abhängigkeiten zwischen den geforderten Randbedingungen und den Schaufelparametern, durch welche sich die Randbedingungen einhalten lassen, vorliegt.

Künstliche neuronale Netze haben sich in zahlreichen technischen Gebieten dabei bewährt, selbständig (anhand von Trainingsdaten) komplexe Zusammenhänge/Abhängigkeiten zwischen verschiedenen Parametern zu erlernen. Insbesondere kann ein (trainiertes) künstliches neuronales Netz dazu genutzt werden, Schaufelparameter einer Strömungsmaschinenschaufel vorherzusagen, mit denen sich gewünschte Randbedingungen einhalten lassen.

Verfahren zum Entwerfen von Strömungsmaschinenschaufeln, insbesondere von Turbinenschaufeln, sind beispielsweise in dem Tagungsbericht "A Neural Network Aero Design System for Advanced Turbo-Engines" von Jose M. Sanz (abrufbar unter: https://ntrs.nasa.gov/search.jsp?R=19990019840) sowie in dem Artikel "The Development of Highly Loaded Turbine Rotating Blades by Using 3D Optimization Design Method of Turbomachinery Blades Based on Artificial Neural Network & Genetic Algorithm" von Fan-zhen Zhou et al. (veröffentlicht in Chinese Journal of Aeronautics Vol. 16 No. 4) offenbart.

Eine Aufgabe der Erfindung ist es, das auf der Verwendung von neuronalen Netzen beruhende Entwerfen einer Strömungsmaschinenschaufel sowie insbesondere die auf einem solchen Entwurfsprozess basierende Herstellung einer zu Strömungsmaschinenschaufel verbessern.

Diese Aufgabe wird erfindungsgemäß gelöst durch ein Verfahren nach Anspruch 1, durch ein Verfahren nach Anspruch 8, durch eine Rechnereinheit nach Anspruch 9 sowie durch ein maschinenlesbares Speichermedium nach Anspruch 10.

Vorteilhafte Ausgestaltungen der Erfindung sind Gegenstand der weiteren Patentansprüche sowie der nachfolgenden Beschreibung.

Bei dem erfindungsgemäßen Verfahren zum Entwerfen einer Strömungsmaschinenschaufel werden vorgegebene Eingabeparameter an ein neuronales Netzwerksystem übermittelt. Von dem neuronalen Netzwerksystem werden Schaufelparameter anhand der übermittelten Eingabeparameter ermittelt und ausgegeben. Erfindungsgemäß ist vorgesehen, dass das neuronale Netzwerksystem mehrere separate neuronale Netze mit jeweils einer Ausgabeschicht aufweist, von denen jedes einen oder mehrere der Schaufelparameter ermittelt und über seine Ausgabeschicht ausgibt. Zu den separaten neuronalen Netzen des neuronalen Netzwerksystems gehören ein erstes neuronales Netz sowie ein zweites neuronales Netz. Weiter ist erfindungsgemäß vorgesehen, dass der/die Schaufelparameter, der/die von dem ersten neuronalen Netz ermittelt und über dessen Ausgabeschicht ausgegeben wird/werden, von dem/den Schaufelparameter/-n, die von dem zweiten neuronalen Netz ermittelt und über dessen Ausgabeschicht ausgegeben wird/werden, verschieden ist/sind.

Anders ausgedrückt, die Erfindung sieht vor, die zu ermittelnden Schaufelparameter von getrennten neuronalen Netzen (also nicht sämtliche zu ermittelnden Schaufelparameter von demselben neuronalen Netz) ermitteln zu lassen. Dadurch hat das jeweilige neuronale Netz des neuronalen Netzwerksystems - verglichen mit dem Fall, dass sämtliche der Schaufelparameter von demselben neuronalen Netz ermittelt werden - weniger (unterschiedliche) Schaufelparameter zu ermitteln und es kann eine Verbesserung der Vorhersagegenauigkeit der vom neuronalen Netzwerksystem ermittelten Schaufelparameter bzw. eine Verringerung der (Vorhersage-)Fehler der vom neuronalen Netzwerksystem ermittelten Schaufelparameter erzielt werden.

Die "Vorhersagegenauigkeit" eines vom neuronalen Netzwerksystem ermittelten Schaufelparameters bezieht sich vorliegend darauf, wie nah der Wert des vom neuronalen Netzwerksystem ermittelten Schaufelparameters am optimalen Schaufelparameterwert liegt, mit dem sich die geforderten Eingabeparameter am besten realisieren lassen. Je näher der Wert des vom neuronalen Netzwerksystem ermittelten Schaufelparameters am optimalen Schaufelparameterwert liegt, desto höher ist die Vorhersagegenauigkeit dieses Schaufelparameters (und desto geringer ist dessen (Vorhersage-)Fehler).

Des Weiteren ermöglicht die auf getrennte neuronale Netze aufgeteilte Schaufelparameter-Ermittlung, physikalisch verwandte Schaufelparameter, verschiedene Dickenparameter, mithilfe desselben neuronalen Netzes zu ermitteln, während andere Schaufelparameter, die miteinander verwandt sind, verschiedene Krümmungsparameter, mithilfe eines anderen neuronalen Netzes des neuronalen Netzwerksystem ermittelt werden. Das heißt, die Aufteilung der Schaufelparameter-Ermittlung auf verschiedene neuronale Netze kann problemspezifisch unter Berücksichtigung physikalischer Zusammenhänge erfolgen. In solch einem Fall wirkt sich die auf getrennte neuronale Netze aufgeteilte Schaufelparameter-Ermittlung besonders vorteilhaft auf die Vorhersagegenauigkeit der Schaufelparameter aus.

Die neuronalen Netze des neuronalen Netzwerksystems sind künstliche neuronale Netze (engl. "artificial neural networks"). Für einen besseren Lesefluss wird in der vorliegenden Beschreibung und in den Patentansprüchen der Begriff "künstlich" weggelassen.

Die zu entwerfende Strömungsmaschinenschaufel kann zum Beispiel eine Turbinenschaufel oder Verdichterschaufel sein, insbesondere für eine Gasturbinenanlage.

Wie zuvor erwähnt, werden vom neuronalen Netzwerksystem bzw. dessen neuronalen Netzen Schaufelparameter ausgegeben. Das heißt, die Schaufelparameter stellen Ausgabeparameter des neuronalen Netzwerksystems bzw. seiner neuronalen Netze dar.

Schaufelparameter im Sinne der vorliegenden Erfindung sind solche Parameter, welche die Strömungsmaschinenschaufel an sich charakterisieren und/oder deren Anordnung/Ausrichtung in einem Schaufelkranz charakterisieren.

Zweckmäßigerweise hat jedes der neuronalen Netze des neuronalen Netzwerksystems zusätzlich zu seiner Ausgabeschicht eine Eingabeschicht.

Die Eingabeparameter, die an das neuronale Netzwerksystem übermittelt werden, beziehen sich vorzugsweise auf gewünschte Randbedingungen für die Strömungsmaschinenschaufel, auf gewünschte Randbedingungen für einen mehrere solche Strömungsmaschinenschaufeln aufweisenden Schaufelkranz und/oder auf gewünschte Randbedingungen für eine (mithilfe der Schaufel bzw. des Schaufelkranzes zu realisierende) Fluidströmung.

Ferner können sich zumindest einige der Schaufelparameter auf einen Schaufelschnitt oder auf unterschiedliche Schaufelschnitte zwischen einem nabenseitigen Ende der Strömungsmaschinenschaufel und einem nabenfernen Ende der Strömungsmaschinenschaufel beziehen.

Wie zuvor erwähnt, gehören zu dem neuronalen Netzwerksystem ein erstes neuronales Netz sowie ein zweites neuronales Netz. Zusätzlich kann das neuronalen Netzwerksystem mindestens ein weiteres neuronales Netz umfassen, welches einen oder mehrere Schaufelparameter ermittelt und über dessen Ausgabeschicht ausgibt, der/die von den Schaufelparametern, die von dem ersten neuronalen Netz und dem zweiten neuronalen Netz ermittelt und werden, verschieden ist/sind.

Das jeweilige neuronale Netz des neuronalen Netzwerksystems wird vor der Ermittlung der Schaufelparameter mithilfe von Trainingsdaten trainiert.

Bei den Trainingsdaten handelt es sich vorzugsweise um eine unechte oder echte Teilmenge eines Grundtrainingsdatenbestands. Der Grundtrainingsdatenbestand kann beispielsweise Daten umfassen, die bei früheren Entwürfen von Strömungsmaschinenschaufeln und/oder bei früheren Optimierungen von Schaufelentwürfen gewonnen wurden. Mit anderen Worten, der Grundtrainingsdatenbestand kann Daten aus früheren Entwurfs- und/oder Optimierungsprojekten umfassen. Diese Daten können insbesondere auf Messungen und/oder Simulationen beruhen.

Es ist vorteilhaft, wenn geprüft wird, ob der Grundtrainingsdatenbestand redundante Parameter enthält. Gegebenenfalls vorhandene redundante Parameter können sodann gefiltert werden. Dadurch kann die Anzahl der zur Ermittlung der Schaufelparameter benötigten Eingabeparameter gering gehalten und die Topologie des neuronalen Netzwerksystems einfach gehalten werden. Darüber hinaus können die Trainingszeiten für die einzelnen neuronalen Netze kurz gehalten werden.

Vorteilhafterweise entsprechen die Trainingsdaten, die zum Trainieren der neuronalen Netze verwendet werden, dem Grundtrainingsdatenbestand oder, falls der Grundtrainingsdatenbestand redundante Parameter enthält, dem um die redundanten Parameter bereinigten Grundtrainingsdatenbestand.

Die Überprüfung, ob der Grundtrainingsdatenbestand redundante Parameter enthält, kann beispielsweise mittels statistischer Methoden, insbesondere anhand von Pearson-Korrelationskoeffizienten, erfolgen. Bevor entschieden wird, ob ein Parameter aus dem Grundtrainingsdatenbestand nicht in die Trainingsdaten eingeht, wird vorzugsweise geprüft, ob dieser Parameter nicht nur aus statistischer Sicht, sondern auch aus physikalischer Sicht redundant ist. Dadurch kann vermieden werden, dass ein Parameter aus dem Grundtrainingsdatenbestand bloß deshalb nicht in die Trainingsdaten eingeht, weil ein zufälliger statistischer Zusammenhang zwischen diesem Parameter und einem weiteren Parameter aus dem Grundtrainingsdatenbestand festgestellt wurde.

Im Sinne der vorliegenden Erfindung kann ein Parameter aus dem Grundtrainingsdatenbestand insbesondere dann redundant sein, wenn zwischen diesem Parameter und einem anderen Parameter aus dem Grundtrainingsdatenbestand eine Korrelation, wie zum Beispiel ein linearer Zusammenhang, besteht. Zur Auffindung von Korrelationen zwischen Parameter aus dem Grundtrainingsdatenbestand können beispielweise Verfahren wie "input merging" oder "adaptive feature selection by using mutual information" genutzt werden.

Die Schaufelparameter, die von dem neuronalen Netzwerksystem ermittelt werden, umfassen geometrische Schaufelparameter.

Zumindest einige der geometrischen Schaufelparameter können beispielsweise einen Schaufelschnitt (also ein Profil der Strömungsmaschinenschaufel) charakterisieren. Weiterhin können sich zumindest einige der geometrischen Schaufelparameter auf unterschiedliche Schaufelschnitte zwischen dem nabenseitigen Ende der Strömungsmaschinenschaufel und nabenfernen Ende der Strömungsmaschinenschaufel beziehen.

Die geometrischen Schaufelparameter können einen oder mehrere Krümmungsparameter oder einen oder mehrere Dickenparameter umfassen.

Bei der Erfindung umfassen die geometrischen Schaufelparameter sowohl einen oder mehrere Krümmungsparameter als auch einen oder mehrere Dickenparameter. Weiter wird der/die Krümmungsparameter von einem anderen neuronalen Netz des neuronalen Netzwerksystems ermittelt und über dessen Ausgabeschicht der/die Dickenparameter ausgegeben.

Besagte/-r Dickenparameter kann/können unter anderem eine Profildicke bei der Hälfte des hinteren Schaufelteils, ein Vorderkantenradius (auch Nasenradius genannt), eine maximale Profildicke, eine Dickenrücklage und/oder ein Hinterkantenwinkel sein bzw. mindestens einen dieser Parameter umfassen.

Im Sinne der vorliegenden Erfindung meint der "hintere Schaufelteil" denjenigen Teil eines Schaufelschnitts/Schaufelprofils, der sich von der Position (auf der Sehnenlinie), bei der sich die maximale Profildicke befindet, bis zur Hinterkante der Strömungsmaschinenschaufel erstreckt. Die "Hälfte" des hinteren Schaufelteils bezieht sich auf den halben Weg von der Position der maximalen Profildicke bis zur Hinterkante der Strömungsmaschinenschaufel (entlang der Sehnenlinie).

Besagte/-r Krümmungsparameter kann/können unter anderem eine maximale Profilwölbung, eine Wölbungsrücklage, ein Winkel zwischen der Sehnenlinie und der Skelettlinie an der Hinterkante und/oder ein Staffelungswinkel sein bzw. mindestens einen dieser Parameter umfassen.

Bei der Erfindung sind die Eingabeparameter, die an das neuronale Netzwerksystem übermittelt werden, zweidimensionale Parameter. Hierbei handelt es sich um Parameter, die jeweils durch ein Wertepaar (also durch zwei zusammengehörige Werte) festgelegt/festlegbar sind. Die Eingabeparameter können beispielsweise eine Machzahlverteilung, insbesondere eine saugseitige Machzahlverteilung und/oder eine druckseitige Machzahlverteilung, repräsentieren. Alternativ oder zusätzlich können die Eingabeparameter mindestens eine Druckverteilung, insbesondere eine saugseitige Druckverteilung und/oder eine druckseitige Druckverteilung, repräsentieren.

Als Machzahlverteilung ist vorliegend eine Machzahl als Funktion der normierten Profiltiefe (engl. "normalized chord") der Strömungsmaschinenschaufel bzw. der Verlauf dieser Funktion zu verstehen. Analog ist als Druckverteilung vorliegend ein Druck als Funktion der normierten Profiltiefe der Strömungsmaschinenschaufel bzw. der Verlauf dieser Funktion zu verstehen.

Ferner ist es vorteilhaft, wenn nach dem Trainieren der neuronalen Netze des neuronalen Netzwerksystems und vor der Ermittlung der Schaufelparameter bei mindestens einem der neuronale Netze mittels eines Pruning-Verfahrens, wie zum Beispiel "optimal brain damage", "early brain damage" oder "inverse kurtosis", eine oder mehrere bestehende Neuronenverbindungen entfernt werden. Auf diese Weise kann dem sogenannten Overfitting vorgebeugt werden. Zudem kann die Generalisationsfähigkeit des neuronalen Netzwerksystems gesteigert werden. Das heißt, die Güte von Ausgaben, auf welche die neuronalen Netze nicht trainiert wurden, kann verbessert und der verbleibende Optimierungsraum für etwaige anschließende Optimierungen verkleinert werden.

Des Weiteren können die Schaufelparameter, die von dem neuronalen Netzwerksystem ermittelt werden, einen Schaufelwirkungsgrad der Strömungsmaschinenschaufel umfassen. Alternativ oder zusätzlich können die Schaufelparameter, die von dem neuronalen Netzwerksystem ermittelt werden, ein logarithmisches Dekrement der Strömungsmaschinenschaufel umfassen. Bei dem logarithmischen Dekrement der Strömungsmaschinenschaufel handelt es sich um ein Maß für das Dämpfungsverhalten der Strömungsmaschinenschaufel.

Besonders bevorzugt ist es, wenn die Schaufelparameter, die von dem neuronalen Netzwerksystem ermittelt werden, zum einen geometrische Schaufelparameter und zum anderen mindestens einen weiteren Schaufelparameter, wie zum Beispiel den Schaufelwirkungsgrad und/oder das logarithmische Dekrement der Strömungsmaschinenschaufel, umfassen. Auf diese Weise ist es insbesondere möglich, Entwurfs-/Auslegungsprozesse unterschiedlichen Fachdisziplinen, wie Fluiddynamik, Festigkeit, Wärmetechnik etc., in einem gemeinsamen Entwurfs-/Auslegungsprozess zu bündeln, anstatt diese wie bisher üblich sukzessive durchzuführen. Solch ein multidisziplinärer Entwurfs-/Auslegungsprozess ermöglicht kürzere Entwurfs-/Auslegungszeiten. Zudem kann ein solcher multidisziplinärer Entwurfs-/Auslegungsprozess den Optimierungsraum für etwaige anschließende Optimierungen der einzelnen Fachdisziplinen bereits stark eingrenzen.

Zu den separaten neuronalen Netzen des neuronalen Netzwerksystems gehört (zusätzlich zu dem ersten und dem zweiten neuronalen Netz) vorteilhafterweise ein drittes neuronales Netz. Es kann beispielsweise vorgesehen sein, dass von dem ersten neuronalen Netz geometrische Schaufelparameter ermittelt und über dessen Ausgabeschicht ausgegeben werden, von dem zweiten neuronalen Netz ein Schaufelwirkungsgrad ermittelt und über dessen Ausgabeschicht ausgegeben wird und von dem dritten neuronalen Netz ein logarithmisches Dekrement der Strömungsmaschinenschaufel ermittelt und über dessen Ausgabeschicht ausgegeben wird. In solch einem Fall liefert das neuronale Netzwerksystem multidisziplinäre Parameter als Schaufelparameter.

Mithilfe der Erfindung kann ein sogenanntes inverses Design der Strömungsmaschinenschaufel erreicht werden. Das heißt, anhand vorgegebener Eingabeparameter können Schaufelparameter, insbesondere geometrische Schaufelparameter, ermittelt und ausgegeben werden, mit denen diese Eingabeparameter realisierbar sind.

Besagte Strömungsgröße/-n kann/können beispielsweise eine Anströmmachzahl, eine Abströmmachzahl, ein Anströmwinkel, ein Umlenkwinkel und/oder eine Schaufelkranzdrehzahl sein bzw. mindestens einen dieser Parameter umfassen.

Besagte geometrische Größe/-n kann/können zum Beispiel ein Hinterkantenradius und/oder ein Teilungsverhältnis sein bzw. mindestens einen dieser Parameter umfassen.

Als Teilungsverhältnis ist vorliegend das Verhältnis einer Steigung eines Schaufelkranzes (also dem Abstand zwischen zwei benachbarten Schaufeln des Schaufelkranzes entlang seiner Umfangslinie) zu einer Profiltiefe der jeweiligen Schaufel zu verstehen.

Des Weiteren kann/können besagte thermodynamische Größe/-n zum Beispiel eine saugseitige Temperatur und/oder eine druckseitige Temperatur sein bzw. mindestens einen dieser Parameter umfassen.

Es ist vorteilhaft, wenn mindestens eines der neuronalen Netze zusätzlich zu seiner besagten Ausgabeschicht eine Eingabeschicht sowie eine Mehrzahl von Zwischenschichten (auch als "hidden layers" bezeichnet) aufweist. Das heißt, vorteilhafterweise ist mindestens eines der neuronalen Netze ein tiefes neuronales Netz (auch "deep neural network" genannt). Zweckmäßigerweise sind die einzelnen Schichten eines solchen mehrere Zwischenschichten aufweisenden neuronalen Netzes hierarchisch miteinander verknüpft. Tiefe neuronale Netze eignen sich besonders gut für die Ermittlung schwer vorhersagbarer (Schaufel-) Parameter.

In bevorzugter Weise wird von mindestens einer der Schichten eines solchen Netzes ein Parameter ermittelt, der an eine der anderen Schichten dieses neuronalen Netzes übermittelt wird.

Auf diese Weise kann zum Beispiel Wissen, das bei der Ermittlung eines leichter vorhersagbaren Parameters gewonnen bzw. erlernt wurde, für die Ermittlung eines schwerer vorhersagbaren Parameters genutzt werden.

Ferner kann vorgesehen sein, dass mindestens eines der neuronalen Netze ein Ensemble von mehreren neuronalen Unternetzen umfasst. Die neuronalen Unternetze des Ensembles können sich beispielsweise hinsichtlich ihrer Netzstruktur voneinander unterscheiden. Vorzugsweise werden an jedes neuronale Unternetz dieses Ensembles die gleichen Eingabeparameter übermittelt.

Vorteilhafterweise wird von jedem neuronalen Unternetz dieses Ensembles jeweils ein Schaufelparameterwert für denselben Schaufelparameter ermittelt. Weiter ist es vorteilhaft, wenn die von den neuronalen Unternetzen des Ensembles ermittelten Schaufelparameterwerte gewichtet oder ungewichtet gemittelt werden, wobei der auf diese Weise erhaltene, gemittelte Schaufelparameterwert von dem besagten neuronalen Netz, dem das Ensemble angehört, über dessen Ausgabeschicht als Schaufelparameter ausgegeben wird. Durch besagte Mittelung kann der Vorhersagefehler des ausgegebenen Schaufelparameters gering gehalten werden, da die Vorhersagefehler der einzelnen Unternetze ausgemittelt werden.

Das besagte neuronale Netz, dem das Ensemble angehört, kann insbesondere mehrere solche Ensembles umfassen. Diese können hierarchisch miteinander verknüpft sein. Mindestens eines der Ensembles kann beispielsweise einen Parameter ermitteln, der an eines der anderen Ensembles dieses neuronalen Netzes als Eingabeparameter übermittelt wird. Auf diese Weise kann zum Beispiel Wissen, das bei der Ermittlung eines leichter vorhersagbaren Parameters gewonnen bzw. erlernt wurde, für die Ermittlung eines schwieriger vorhersagbaren Parameters genutzt werden.

Der Parameter, der von einem der Ensembles an eines der anderen Ensembles dieses neuronalen Netzes übermittelt wird, ist vorzugsweise ein Schaufelparameter, der von dem besagten neuronalen Netz, dem die Ensembles angehören, über dessen Ausgabeschicht ausgegeben wird.

Ferner kann mindestens eines der Unternetze des jeweiligen Ensembles als ein sogenanntes "deep neural network" ausgebildet sein.

Wie eingangs erwähnt, betrifft die Erfindung ein Verfahren zum Herstellen einer Strömungsmaschinenschaufel.

Das erfindungsgemäße Verfahren zum Herstellen einer Strömungsmaschinenschaufel umfasst die Schritte:
- Entwerfen einer Strömungsmaschinenschaufel gemäß dem erfindungsgemäßen Verfahren zum Entwerfen einer Strömungsmaschinenschaufel, wobei Schaufelparameter ermittelt werden,
- gegebenenfalls Abwandeln eines oder mehrerer der Schaufelparameter unter Berücksichtigung mindestens eines Optimierungskriteriums,
- Herstellen der Strömungsmaschinenschaufel entsprechend den ermittelten, gegebenenfalls abgewandelten Schaufelparametern.

Der zweite Schritt des Herstellungsverfahrens ist optional. Das heißt, die Strömungsmaschinenschaufel kann entsprechend den mithilfe des neuronalen Netzwerksystems ermittelten Schaufelparametern hergestellt werden, ohne dass die ermittelten Schaufelparameter unter Berücksichtigung mindestens eines Optimierungskriteriums abgewandelt werden.

Beim Herstellen der Strömungsmaschinenschaufel kann insbesondere ein generatives Fertigungsverfahren, wie zum Beispiel selektives Laserschmelzen, selektives Lasersintern oder dergleichen, zum Einsatz kommen.

Die Erfindung betrifft außerdem, wie eingangs erwähnt, eine Rechnereinheit sowie ein maschinenlesbares Speichermedium.

Weiter oben im Zusammenhang mit dem erfindungsgemäßen Verfahren zum Entwerfen einer Strömungsmaschinenschaufel beschriebene Ausführungsformen, Ausführungsdetails und Vorteile können sich auch auf die erfindungsgemäße Rechnereinheit und das erfindungsgemäße Speichermedium beziehen.

Die erfindungsgemäße Rechnereinheit ist zur Durchführung des erfindungsgemäßen Verfahrens zum Entwerfen einer Strömungsmaschinenschaufel eingerichtet. Die Rechnereinheit umfasst ein neuronales Netzwerksystem, welches dazu eingerichtet ist, vorgegebene Eingabeparameter zu empfangen und Schaufelparameter anhand der empfangenen Eingabeparameter zu ermitteln und auszugeben. Erfindungsgemäß umfasst das neuronale Netzwerksystem der Rechnereinheit mehrere separate neuronale Netze mit jeweils einer Ausgabeschicht, von denen jedes dazu eingerichtet ist, einen oder mehrere der Schaufelparameter zu ermitteln und über seine Ausgabeschicht auszugeben. Zu den separaten neuronalen Netzen gehören ein erstes neuronales Netz sowie ein zweites neuronales Netz. Das erste neuronale Netz ist dazu eingerichtet, einen oder mehrere der Schaufelparameter zu ermitteln und über seine Ausgabeschicht auszugeben. Ferner ist das zweite neuronale Netz dazu eingerichtet, einen oder mehrere der Schaufelparameter zu ermitteln und über seine Ausgabeschicht auszugeben, welcher/welche von dem/den vom ersten neuronalen Netz ermittelten und ausgegebenen Schaufelparameter/-n verschieden ist/sind.

Die Einrichtung der Rechnereinheit zur Durchführung der angegebenen Verfahrensschritte kann durch Ausrüsten der Rechnereinheit mit einem entsprechenden Computerprogramm erfolgen, welches die Rechnereinheit zur Durchführung der Verfahrensschritte befähigt.

Das erfindungsgemäße maschinenlesbare Speichermedium weist einen Programmcode auf, durch welchen eine Rechnereinheit zur Ausführung des erfindungsgemäßen Verfahrens zum Entwerfen einer Strömungsmaschinenschaufel veranlasst wird, wenn der Programmcode von der Recheneinheit ausgeführt wird.

Das maschinenlesbare Speichermedium kann ein Bestandteil der erfindungsgemäßen Rechnereinheit sein oder mit der erfindungsgemäßen Rechnereinheit verbunden sein.

Die bisher gegebene Beschreibung bevorzugter Ausgestaltungen der Erfindung enthält zahlreiche Merkmale, die in den einzelnen abhängigen Patentansprüchen teilweise zu mehreren zusammengefasst wiedergegeben sind. Diese Merkmale können jedoch auch einzeln betrachtet und zu sinnvollen weiteren Kombinationen zusammengefasst werden. Insbesondere sind diese Merkmale jeweils einzeln und in beliebiger geeigneter Kombination mit den erfindungsgemäßen Verfahren, der erfindungsgemäßen Rechnereinheit sowie dem erfindungsgemäßen Speichermedium kombinierbar. Ferner können Verfahrensmerkmale auch als Eigenschaft der entsprechenden Vorrichtungseinheit angesehen werden.

Die oben beschriebenen Eigenschaften, Merkmale und Vorteile der Erfindung sowie die Art und Weise, wie diese erreicht werden, werden klarer und deutlicher verständlich im Zusammenhang mit der folgenden Beschreibung der Ausführungsbeispiele der Erfindung, die im Zusammenhang mit den Figuren näher erläutert werden. Die Ausführungsbeispiele dienen der Erläuterung der Erfindung und beschränken die Erfindung nicht auf die darin angegebenen Kombinationen von Merkmalen, auch nicht in Bezug auf funktionale Merkmale. Außerdem können dazu geeignete Merkmale eines jeden Ausführungsbeispiels auch explizit isoliert betrachtet, aus einem Ausführungsbeispiel entfernt, in ein anderes Ausführungsbeispiel zu dessen Ergänzung eingebracht und mit einem beliebigen der Ansprüche kombiniert werden.

Es zeigen:
- FIG 1: ein Ausführungsbeispiel einer ersten erfindungsgemäßen Rechnereinheit zum Entwerfen einer Strömungsmaschinenschaufel;
- FIG 2: ein Profil einer Strömungsmaschinenschaufel;
- FIG 3: eine schematische Darstellung eines neuronalen Netzes, in welcher verschiedene Schichten von Neuronen des neuronalen Netzes abgebildet sind;
- FIG 4: ein Diagramm, in welchem eine druckseitige sowie eine saugseitige Machzahlverteilung dargestellt sind;
- FIG 5: eine schematische Darstellung eines neuronalen Netzes, das ein Ensemble von mehreren Unternetzen umfasst;
- FIG 6: ein Ausführungsbeispiel einer zweiten erfindungsgemäßen Rechnereinheit zum Entwerfen einer Strömungsmaschinenschaufel.

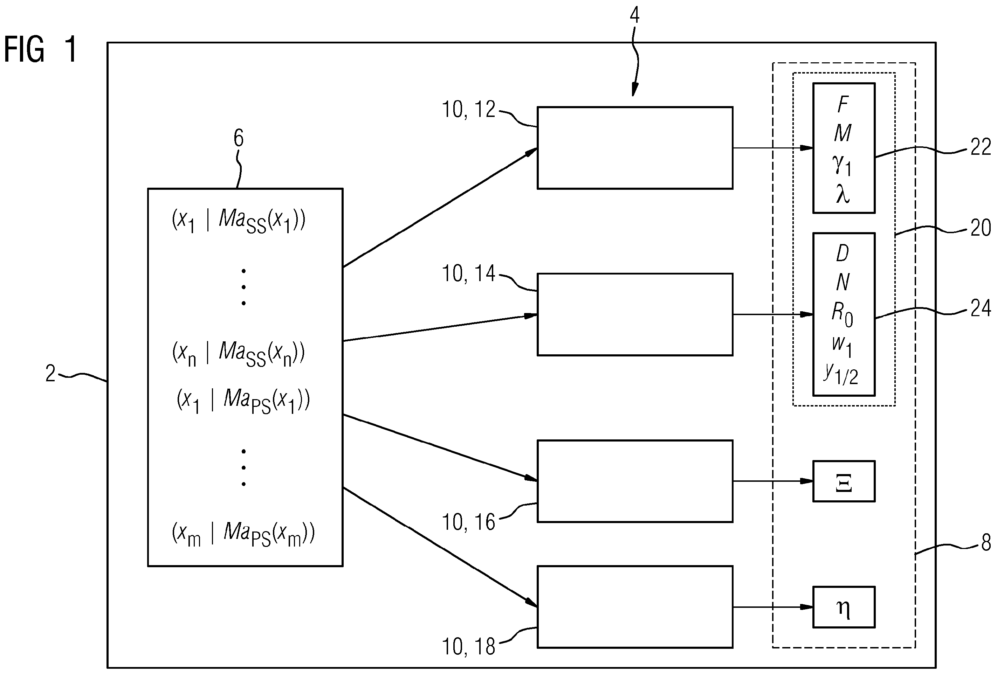

FIG 1 zeigt schematisch eine erste Rechnereinheit 2 zum Entwerfen einer Strömungsmaschinenschaufel.

Diese Rechnereinheit 2 umfasst ein neuronales Netzwerksystem 4, welches dazu eingerichtet ist, vorgegebene Eingabeparameter 6 zu empfangen sowie mehrere Schaufelparameter 8, welche die zu entwerfende Strömungsmaschinenschaufel und deren vorgesehene Anordnung/Ausrichtung in einem Schaufelkranz charakterisieren, anhand der empfangenen Eingabeparameter 6 zu ermitteln und auszugeben.

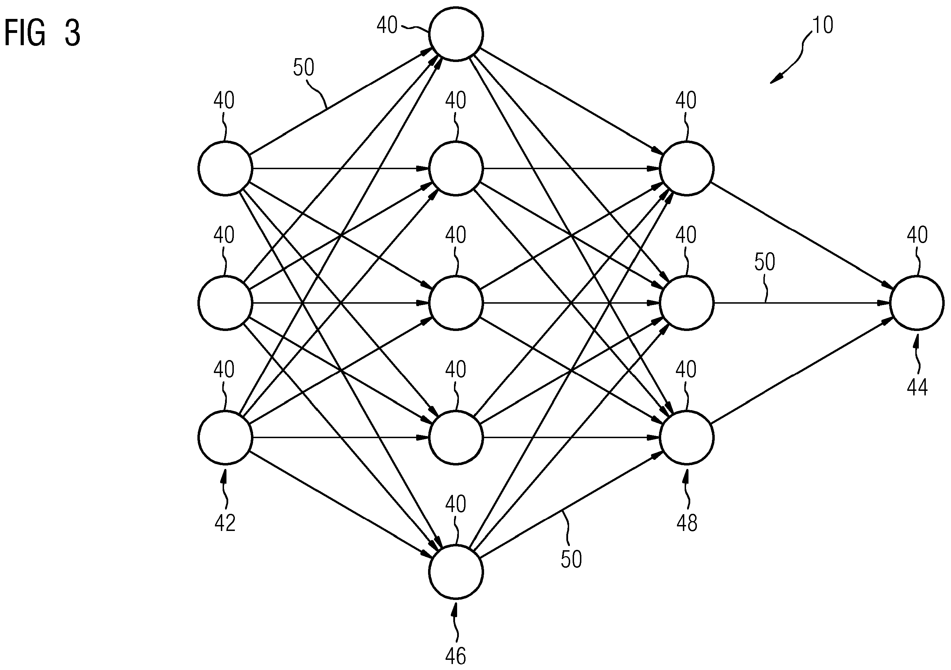

Das neuronale Netzwerksystem 4 umfasst mehrere separate neuronale Netze 10, von denen jedes eine Ausgabeschicht (vgl. FIG 3) aufweist. Bei dem Ausführungsbeispiel nach FIG 1 umfasst das neuronale Netzwerksystem 4 ein erstes neuronales Netz 12, ein zweites neuronales Netz 14, ein drittes neuronales Netz 16 sowie eine viertes neuronales Netz 18.

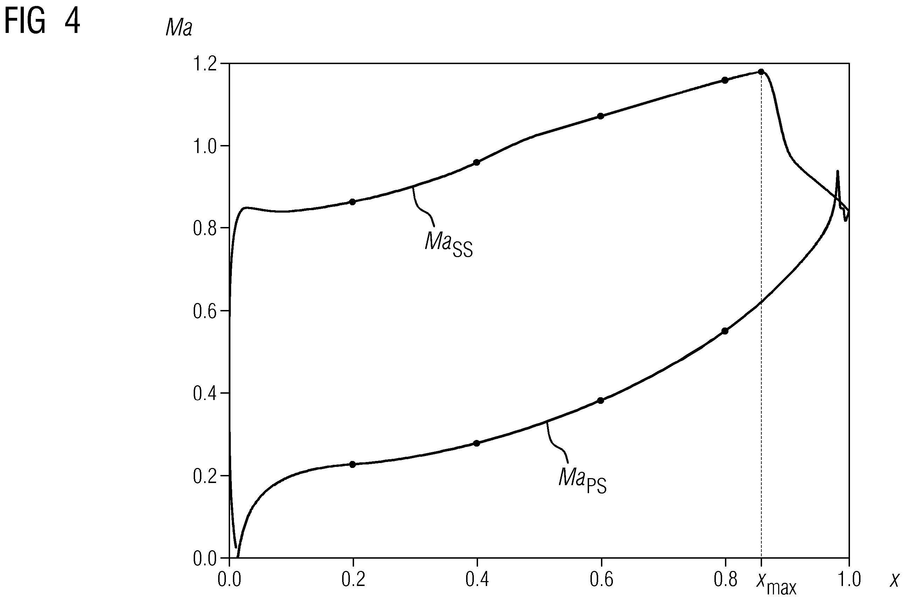

Die Eingabeparameter 6, anhand derer das neuronale Netzwerksystem 4 die Schaufelparameter 8 ermittelt und ausgibt, werden an jedes der vier neuronalen Netze 12-18 übermittelt. Im vorliegenden Ausführungsbeispiel umfassen die Eingabeparameter 6 n zweidimensionale Parameter, die eine saugseitige Machzahlverteilung *Ma*_{SS} um einen Schaufelschnitt repräsentieren, sowie m zweidimensionale Parameter, die eine druckseitige Machzahlverteilung *Ma*_{PS} um besagten Schaufelschnitt repräsentieren (vgl. FIG 4), wobei n und m natürliche Zahlen größer als 1 sind. Mit anderen Worten, die Eingabeparameter 6 stellen n Punkte einer saugseitigen Machzahlverteilung *Ma*_{SS} und m Punkte einer druckseitigen Machzahlverteilung *Ma*_{PS} dar. Jeder der Eingabeparameter 6 umfasst als ersten Wert eine normierte Profiltiefe *x*ᵢ und als zweiten Wert die zugehörige saugseitige Machzahl *Ma*_{SS}(*X*ᵢ) bzw. druckseitige Machzahl *Ma*_{PS} (*X*ᵢ).

Die Ermittlung der Schaufelparameter 8 wird auf die vier neuronalen Netze 12-18 aufgeteilt, wobei jedes der vier neuronalen Netze 12-18 einen oder mehrere der Schaufelparameter 8 ermittelt und über seine Ausgabeschicht ausgibt und wobei derjenige/diejenigen Schaufelparameter, die von dem jeweiligen neuronalen Netz 12-18 ermittelt und über seine Ausgabeschicht ausgegeben wird/werden, von den Schaufelparametern verschieden ist/sind, die von den anderen neuronalen Netzen 12-18 ermittelt und ausgegeben werden.

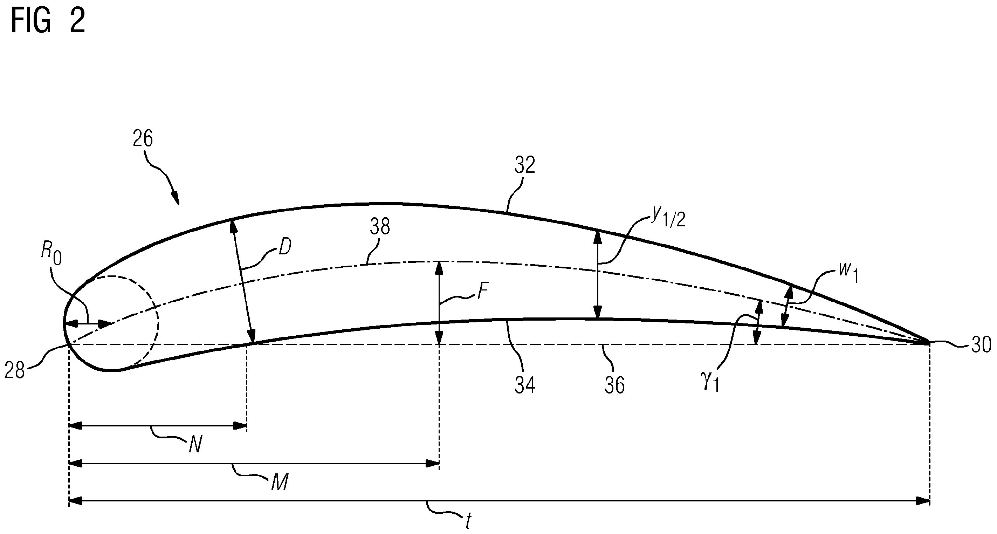

Bei den von dem ersten und dem zweiten neuronalen Netz 12, 14 ermitteln Schaufelparametern handelt es sich um geometrische Schaufelparameter 20. Im vorliegenden Ausführungsbeispiel werden vom ersten neuronalen Netz 12 Krümmungsparameter 22 eines Schaufelprofils (hier exemplarisch eine maximale Profilwölbung F, eine Wölbungsrücklage M, ein Winkel γ₁ zwischen der Sehnenlinie und der Skelettlinie an der Schaufelhinterkante (vgl. FIG 2) sowie ein Staffelungswinkel λ) ermittelt und über dessen Ausgabeschicht ausgegeben. Vom zweiten neuronalen Netz 14 hingegen werden Dickenparameter 24 dieses Schaufelprofils (hier exemplarisch eine Profildicke *y*_{1/2} bei der Hälfte des hinteren Schaufelteils, ein Vorderkantenradius *R*₀, eine maximale Profildicke D, eine Dickenrücklage N sowie ein Hinterkantenwinkel *w*₁) ermittelt und über dessen Ausgabeschicht ausgegeben.

Des Weiteren wird vom dritten neuronalen Netz 16 ein logarithmisches Dekrement Ξ der Strömungsmaschinenschaufel als Schaufelparameter ermittelt und über dessen Ausgabeschicht ausgegeben. Vom vierten neuronalen Netz 18 wird ein Schaufelwirkungsgrad η als Schaufelparameter ermittelt und über dessen Ausgabeschicht ausgegeben.

Grundsätzlich kann das neuronale Netzwerksystem 4 eine andere Anzahl von neuronalen Netzen 10, 12-18 aufweisen. Ferner kann die Ermittlung der Schaufelparameter 8 prinzipiell anders auf die einzelnen neuronalen Netze 10, 12-18 aufgeteilt sein.

Bevor die Schaufelparameter 8 mithilfe des neuronalen Netzwerksystems 4 ermittelt werden, wird jedes der vier neuronalen Netze 12-18 mithilfe von Trainingsdaten trainiert, die auf einem Grundtrainingsdatenbestand basieren, der Daten aus früheren Entwurfs- und/oder Optimierungsprojekten enthält. Vor dem Training der neuronalen Netze 12-18 wird zunächst geprüft, ob der Grundtrainingsdatenbestand redundante Parameter enthält. Enthält der Grundtrainingsdatenbestand redundante Parameter, dienen als Trainingsdaten die um die redundanten Parameter bereinigten Daten des Grundtrainingsdatenbestands. Andernfalls werden sämtliche Daten des Grundtrainingsdatenbestands als Trainingsdaten verwendet.

Nach dem Trainieren der neuronalen Netze 12-18 und vor der Ermittlung der Schaufelparameter 8 werden gegebenenfalls bei einem oder mehreren der neuronalen Netze 12-18 mittels eines Pruning-Verfahrens jeweils eine oder mehrere bestehende Neuronenverbindungen (vgl. FIG 3) entfernt.

Auf das oben beschriebene Entwerfen einer Strömungsmaschinenschaufel folgt eine Herstellung der Strömungsmaschinenschaufel.

Vor der Herstellung der Strömungsmaschinenschaufel kann gegebenenfalls mindestens einer der vom neuronalen Netzwerksystem 4 ermittelten und ausgegebenen Schaufelparameter 8 unter Berücksichtigung mindestens eines Optimierungskriteriums abgewandelt werden.

Die Herstellung der Strömungsmaschinenschaufel erfolgt gemäß den vom neuronalen Netzwerksystem 4 ermittelten, gegebenenfalls abgewandelten Schaufelparametern, beispielsweise mithilfe eines generativen Fertigungsverfahrens.

FIG 2 zeigt ein exemplarisches Profil einer Strömungsmaschinenschaufel 26.

Die Strömungsmaschinenschaufel 26 umfasst eine Vorderkante 28 (engl. "leading edge") sowie eine Hinterkante 30 (engl. "trailing edge"). Ferner weist die Strömungsmaschinenschaufel 26 eine Schaufeloberseite 32 und eine Schaufelunterseite 34 auf.

In FIG 2 sind sowohl eine Sehnenlinie 36 als auch eine Skelettlinie 38 der Strömungsmaschinenschaufel 26 abgebildet. Darüber hinaus sind in FIG 2 einige der zuvor erwähnten Schaufelparameter 8 kenntlich gemacht.

Zu den in FIG 2 kenntlich gemachten Schaufelparametern 8 gehören unter anderem die Profiltiefe t der Strömungsmaschinenschaufel 26 (d. h. die Länge der Sehnenlinie 36), der Vorderkantenradius *R*₀, die maximale Profildicke D, die maximale Profilwölbung F (also die größte Abweichung der Skelettlinie 38 von der Sehnenlinie 36), der Hinterkantenwinkel *w*₁ (d. h. der Winkel zwischen der Schaufeloberseite 32 und der Schaufelunterseite 34 an der Hinterkante 30) und der Winkel γ₁ zwischen der Sehnenlinie 36 und der Skelettlinie 38 an der Hinterkante 30. Darüber hinaus gehören zu den in FIG 2 kenntlich gemachten Schaufelparametern 8 die Wölbungsrücklage M (also den Abstand der Position der maximalen Profilwölbung F zur Vorderkante 28 entlang der Sehnenlinie 36), die Dickenrücklage N (also den Abstand der Position der maximalen Profildicke D zur Vorderkante 28 entlang der Sehnenlinie 36) sowie die Profildicke y_{1/2} bei der Hälfte des hinteren Schaufelteils.

FIG 3 zeigt eine schematische Darstellung, welche den prinzipiellen Aufbau eines neuronalen Netzes 10 illustriert.

Das in FIG 3 dargestellte neuronale Netz 10 umfasst eine Vielzahl künstlicher Neuronen 40, die mehrere Schichten bilden. Im vorliegenden Fall bilden die Neuronen 40 eine Eingabeschicht 42 zum Empfangen von Eingabeparametern, eine Ausgabeschicht 44 sowie eine erste Zwischenschicht 46 und eine zweite Zwischenschicht 48. Über die Ausgabeschicht 44 des neuronalen Netzes 10 wird/werden ein bzw. mehrere Ausgabeparameter ausgegeben, der/die von dem neuronalen Netz 10 anhand der Eingabeparameter ermittelt wird/werden.

Bei dem neuronalen Netz 10 aus FIG 3 umfassen die Eingabeschicht 42 und die zweite Zwischenschicht 48 drei Neuronen 40, während die erste Zwischenschicht 46 fünf Neuronen 40 umfasst und die Ausgabeschicht 44 ein Neuron 40 umfasst, wobei die Anzahl der Neuronen 40 der jeweiligen Schicht 42-48 lediglich exemplarisch gewählt wurde.

Die einzelnen Schichten 42-48 des neuronalen Netzes 10 sind durch Neuronenverbindungen 50, die jeweils zwei der Neuronen 40 miteinander verbinden, miteinander verknüpft. Im vorliegenden Fall ist jedes Neuron 40 der Eingabeschicht 42 mit jedem Neuron 40 der ersten Zwischenschicht 46 verbunden. Weiter sind die Neuronen 40 der ersten Zwischenschicht 46 jeweils mit jedem Neuron 40 der zweiten Zwischenschicht 48 verbunden.

Jedes Neuron 40 der zweiten Zwischenschicht 48 ist seinerseits mit dem Neuron 40 der Ausgabeschicht 44 verbunden.

Die vier zuvor erwähnten neuronalen Netze 12-18 des neuronalen Netzwerksystems 4 aus FIG 1 können jeweils einen solchen Aufbau oder einen ähnlichen Aufbau aufweisen. Insbesondere kann das jeweilige neuronale Netz 12-18 des neuronalen Netzwerksystems 4 eine andere Anzahl von Zwischenschichten 46, 48, eine andere Anzahl von Neuronen 40 sowie eine andere Anzahl von Neuronenverbindungen 50 aufweisen.

FIG 4 zeigt ein Achsendiagramm, dessen Ordinatenachse eine Machzahl *Ma* darstellt und dessen Abszissenachse die normierte Profiltiefe x einer Strömungsmaschinenschaufel darstellt, wobei der Wert 0 der normierten Profiltiefe x der Vorderkantenposition der Strömungsmaschinenschaufel entspricht und der Wert 1 der Profiltiefe x der Hinterkantenposition der Strömungsmaschinenschaufel entspricht.

In dem Diagramm sind eine exemplarische saugseitige Machzahlverteilung *Ma*_{SS} um einen Schaufelschnitt sowie eine exemplarische druckseitige Machzahlverteilung *Ma*_{PS} um diesen Schaufelschnitt abgebildet.

Ferner sind in FIG 4 einige Punkte der saugseitigen Machzahlverteilung *Ma*_{SS} sowie einige Punkte der druckseitigen Machzahlverteilung *Ma*_{PS} eingezeichnet, die zum Beispiel als Eingabeparameter an das neuronale Netzwerksystem 4 aus FIG 1 übermittelt werden können.

Konkret handelt es sich bei der saugseitigen Machzahlverteilung *Ma*_{SS} um die Punkte: (0.2 | *Ma*_{SS} (0.2)), (0.4 |*Ma*_{SS} (0.4)), (0.6 | *Ma*_{SS} (0. 6)), (0.8 | *Ma*_{SS} (0.8)) und (*X*ₘₐₓ | *Ma*_{SS} (*X*ₘₐₓ)). Bei der druckseitigen Machzahlverteilung *Ma*_{PS} handelt es sich um die Punkte: (0.2 | *Ma*_{PS} (0.2)), (0.4 | *Ma*_{*P*S} (0.4)), (0.6 | *Ma*_{PS} (0.6)) und (0.8 | *Ma*_{PS} (0.8)). Alternativ oder zusätzlich können andere Punkte der saugseitigen Machzahlverteilung *Ma*_{SS} und/oder andere Punkte der druckseitigen Machzahlverteilung *Ma*_{PS} als Eingabeparameter an das neuronale Netzwerksystem 4 aus FIG 1 übermittelt werden.

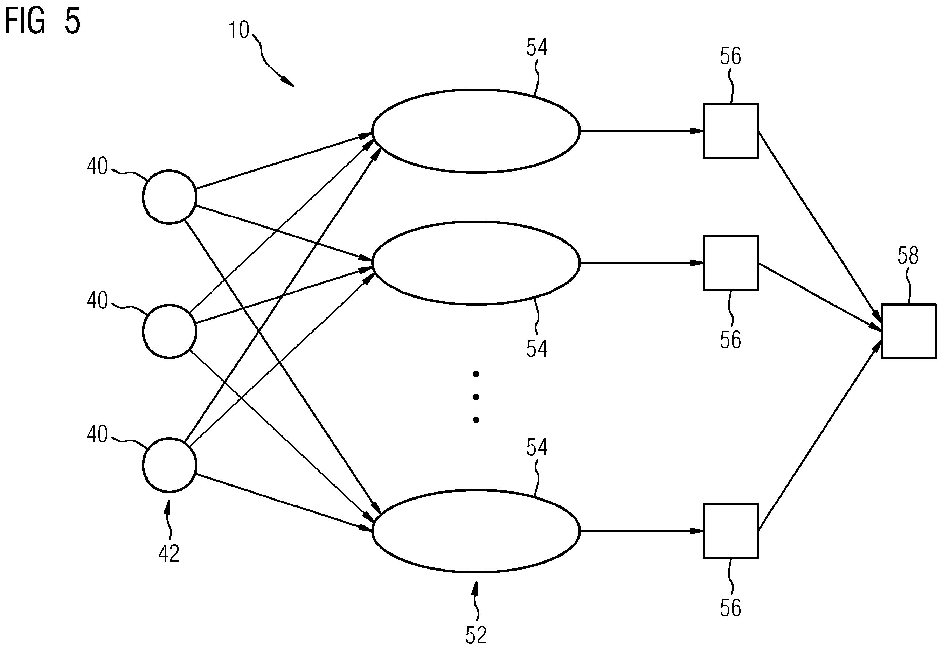

FIG 5 zeigt eine schematische Darstellung eines neuronalen Netzes 10 zur Ermittlung eines oder mehrerer Schaufelparameter.

Das neuronale Netz 10 aus FIG 5 hat eine Eingabeschicht 42, die mehrere künstliche Neuronen 40 umfasst. Weiter umfasst dieses neuronale Netz 10 ein Ensemble 52 von mehreren neuronalen Unternetzen 54, die jeweils mit der Eingabeschicht 42 verknüpft sind. Das Ensemble 52 von neuronalen Unternetzen 54 wird vorzugsweise durch Neuronen einer oder mehrerer (in FIG 5 nicht dargestellter) Zwischenschichten des neuronalen Netzes 10 ausgebildet.

Von der Eingabeschicht 42 bzw. deren Neuronen 40 werden Eingabeparameter empfangen, die an jedes der neuronalen Unternetze 54 des Ensembles 52 übermittelt werden. Von jedem neuronalen Unternetz 54 des Ensembles 52 wird anhand der Eingabeparameter jeweils ein Schaufelparameterwert 56 für denselben Schaufelparameter (beispielsweise für die maximale Profildicke D) ermittelt. Die einzelnen Schaufelparameterwerte 56 werden (gewichtet oder ungewichtet) gemittelt, wodurch ein gemittelter Schaufelparameterwert 58 erhalten wird. Der gemittelte Schaufelparameterwert 58 wird von dem neuronalen Netz 10 über dessen (in FIG 5 nicht dargestellte) Ausgabeschicht als Schaufelparameter ausgegeben.

Gegebenenfalls kann das neuronale Netz 10 mindestens ein weiteres derartiges Ensemble von neuronalen Unternetzen aufweisen, das zur Ermittlung eines weiteren Schaufelparameters dient. In solch einem Fall kann der gemittelte Schaufelparameterwert 58 neben den zuvor erwähnten Eingabeparametern als zusätzlicher Parameter an das weitere Ensemble bzw. dessen neuronale Unternetze übermittelt werden, sodass der gemittelte Schaufelparameter 58 in die Ermittlung des weiteren Schaufelparameters eingehen kann.

Eines oder mehrere der vier neuronalen Netze 12-18 des neuronalen Netzwerksystems 4 aus FIG 1 können den gleichen Aufbau und die gleiche Funktionsweise wie das neuronale Netz 10 aus FIG 5 haben.

Die Beschreibung des nachfolgenden Ausführungsbeispiels beschränkt sich primär auf die Unterschiede zum vorhergehenden Ausführungsbeispiel, auf das bezüglich gleicher Merkmale und Funktionen verwiesen wird. Gleiche und/oder einander entsprechende Elemente sind, soweit zweckdienlich, mit den gleichen Bezugszeichen bezeichnet und nicht erwähnte Merkmale sind im nachfolgenden Ausführungsbeispiel übernommen, ohne dass sie erneut beschrieben werden.

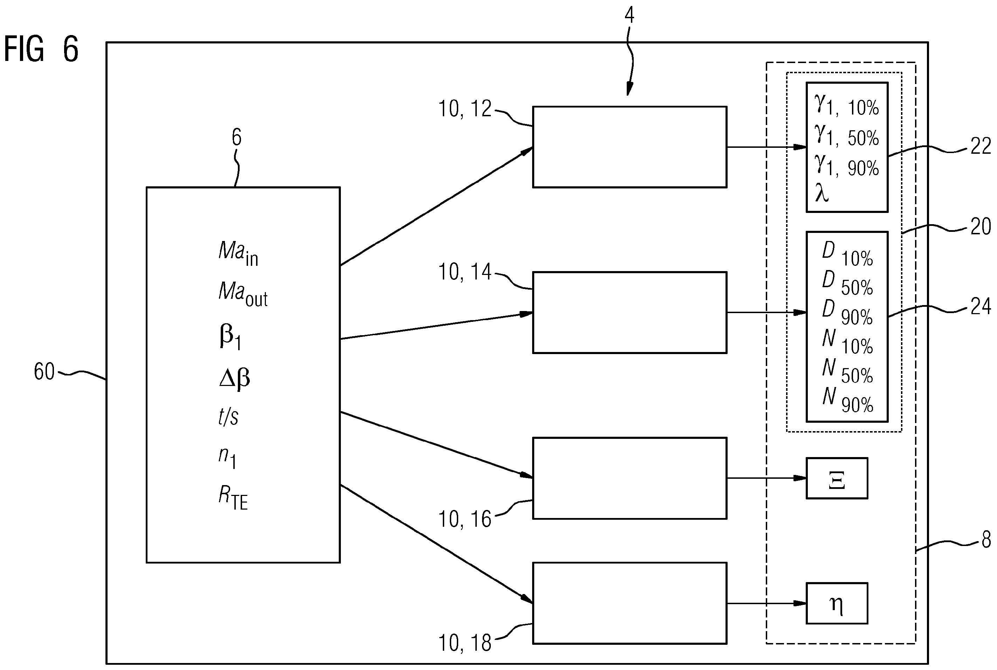

FIG 6 zeigt schematisch eine zweite Rechnereinheit 60 zum Entwerfen einer Strömungsmaschinenschaufel.

Ebenso wie die Rechnereinheit 2 aus FIG 1 umfasst auch die Rechnereinheit 60 aus FIG 6 ein neuronales Netzwerksystem 4 mit einem ersten, einem zweiten, einem dritten und einem vierten neuronalen Netz 12-18.

Im vorliegenden Ausführungsbeispiel werden eindimensionale Parameter als Eingabeparameter 6 an die vier neuronalen Netze 12-18 des neuronalen Netzwerksystems 4 übermittelt. Die Eingabeparameter 6 umfassen in diesem Fall mehrere Strömungsgrö-βen (hier exemplarisch eine Anströmmachzahl *Ma*ᵢₙ, eine Abströmmachzahl *Ma*ₒᵤₜ, einen Anströmwinkel β₁, einen Umlenkwinkel Δβ und eine vorgesehene Schaufelkranzdrehzahl *n*₁). Zusätzlich umfassen die Eingabeparameter 6 geometrische Größen (hier exemplarisch einen vorgesehenen Hinterkantenradius *R*_{TE} und ein vorgesehenes Teilungsverhältnis t/s).

Wie im vorhergehenden Ausführungsbeispiel werden auch im vorliegenden Ausführungsbeispiel von dem ersten und dem zweiten neuronalen Netz 12, 14 geometrische Schaufelparameter 20 ermittelt und ausgegeben.

Vom ersten neuronalen Netz 12 werden dabei Krümmungsparameter 22 (hier exemplarisch ein Staffelungswinkel λ sowie für verschiedene Schaufelschnitte zwischen einem nabenseitigen Ende und einem nabenfernen Ende der Strömungsmaschinenschaufel jeweils der Winkel γ₁ zwischen der Sehnenlinie und der Skelettlinie an der Schaufelhinterkante) ermittelt und über dessen Ausgabeschicht ausgegeben. Vom zweiten neuronalen Netz 14 hingegen werden Dickenparameter 24 (hier exemplarisch für verschiedene Schaufelschnitte zwischen dem nabenseitigen Ende und dem nabenfernen Ende der Strömungsmaschinenschaufel jeweils die maximale Profildicke D und die Dickenrücklage N) ermittelt und über dessen Ausgabeschicht ausgegeben.

Die in Prozent angegebenen Indizes bei einigen der Schaufelparameter 8 in FIG 6 stehen jeweils für die Position des Schaufelschnitts, auf den sich der jeweilige Schaufelparameter bezieht. Die Bedeutung dieser (in Prozent angegebenen) Indizes ist vorliegend wie folgt definiert: Ein Index von 0% entspricht dem nabenseitigen Ende der Strömungsmaschinenschaufel, während ein Index von 100% dem nabenferne Ende der Strömungsmaschinenschaufel entspricht. Dem Index 50% entspricht somit eine Position mittig zwischen dem nabenseitigen Ende und dem nabenfernen Ende der Strömungsmaschinenschaufel.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können hieraus abgeleitet werden, ohne den Schutzumfang der Erfindung zu verlassen.

## Patentansprüche

1. Mittels einer Rechnereinheit durchgeführtes Verfahren zum Entwerfen einer Strömungsmaschinenschaufel (26), bei dem vorgegebene Eingabeparameter (6) an ein neuronales Netzwerksystem (4) übermittelt werden und von dem neuronalen Netzwerksystem (4) Schaufelparameter (8) anhand der übermittelten Eingabeparameter (6) ermittelt und ausgegeben werden,
wobei das neuronale Netzwerksystem (4) mehrere separate neuronale Netze (10, 12-18) mit jeweils einer Ausgabeschicht (44) aufweist, von denen jedes einen oder mehrere der Schaufelparameter (8) ermittelt und über seine Ausgabeschicht (44) ausgibt, wobei zu den separaten neuronalen Netzen (10, 12-18) des neuronalen Netzwerksystems (4) ein erstes neuronales Netz sowie ein zweites neuronales Netz gehören und der/die Schaufelparameter, der/die von dem ersten neuronalen Netz ermittelt und über dessen Ausgabeschicht (44) ausgegeben wird/werden, von dem/den Schaufelparameter/-n, die von dem zweiten neuronalen Netz ermittelt und über dessen Ausgabeschicht (44) ausgegeben wird/werden, verschieden ist/sind, und
wobei das jeweilige neuronale Netz des neuronalen Netzwerksystems vor der Ermittlung der Schaufelparameter mithilfe von Trainingsdaten trainiert wird,
wobei die Schaufelparameter (8), die von dem neuronalen Netzwerksystem (4) ermittelt werden, geometrische Schaufelparameter (20) umfassen,
wobei die geometrischen Schaufelparameter (20)
- einen oder mehrere Krümmungsparameter (22) sowie einen oder mehrere Dickenparameter (24) umfassen, wobei der/die Krümmungsparameter (22) von einem anderen neuronalen Netz (10, 12-18) des neuronalen Netzwerksystems (4) ermittelt und über dessen Ausgabeschicht (44) ausgegeben wird/werden als der/die Dickenparameter (24)
und,
dass die Eingabeparameter (6), die an das neuronale Netzwerksystem (4) übermittelt werden, zweidimensionale Parameter sind, wobei die Eingabeparameter (6) mindestens eine Machzahlverteilung (*Ma*_{SS}, *Ma*_{PS}) und/oder mindestens eine Druckverteilung repräsentieren.

2. Verfahren nach Anspruch 1,
**dadurch gekennzeichnet, dass** vor der Ermittlung der Schaufelparameter (8) das jeweilige neuronale Netz (10, 12-18) des neuronalen Netzwerksystems (4) mithilfe von Trainingsdaten trainiert wird, welche eine unechte oder echte Teilmenge eines Grundtrainingsdatenbestands sind, wobei geprüft wird, ob der Grundtrainingsdatenbestand redundante Parameter enthält, und die Trainingsdaten, die zum Trainieren der neuronalen Netze (10, 12-18) verwendet werden, dem Grundtrainingsdatenbestand oder, falls der Grundtrainingsdatenbestand redundante Parameter enthält, dem um die redundanten Parameter bereinigten Grundtrainingsdatenbestand entsprechen.

3. Verfahren nach Anspruch 1 oder 2,
**dadurch gekennzeichnet, dass** vor der Ermittlung der Schaufelparameter (8) das jeweilige neuronale Netz (10, 12-18) des neuronalen Netzwerksystems (4) mithilfe von Trainingsdaten trainiert wird, wobei nach dem Trainieren der neuronalen Netze (10, 12-18) des neuronalen Netzwerksystems (4) und vor der Ermittlung der Schaufelparameter (8) bei mindestens einem der neuronalen Netze (10, 12-18) mittels eines Pruning-Verfahrens eine oder mehrere bestehende Neuronenverbindungen (50) entfernt werden.

4. Verfahren nach einem der voranstehenden Ansprüche,
**dadurch gekennzeichnet, dass** die Schaufelparameter (8), die von dem neuronalen Netzwerksystem (4) ermittelt werden, einen Schaufelwirkungsgrad (η) der Strömungsmaschinenschaufel (26) und/oder ein logarithmisches Dekrement (Ξ) der Strömungsmaschinenschaufel (26) umfassen.

5. Verfahren nach einem der voranstehenden Ansprüche,
**dadurch gekennzeichnet, dass** zu den separaten neuronalen Netzen (10, 12-18) des neuronalen Netzwerksystems (4) ein drittes neuronales Netz gehört, wobei von dem ersten neuronalen Netz geometrische Schaufelparameter (20) ermittelt und über dessen Ausgabeschicht ausgegeben werden, von dem zweiten neuronalen Netz ein Schaufelwirkungsgrad (η) ermittelt und über dessen Ausgabeschicht (44) ausgegeben wird und von dem dritten neuronalen Netz ein logarithmisches Dekrement (Ξ) der Strömungsmaschinenschaufel (26) ermittelt und über dessen Ausgabeschicht (44) ausgegeben wird.

6. Verfahren nach einem der voranstehenden Ansprüche,
**dadurch gekennzeichnet, dass** mindestens eines der neuronalen Netze (10, 12-18) zusätzlich zu seiner besagten Ausgabeschicht (44) eine Mehrzahl von Zwischenschichten (46, 48) aufweist.

7. Verfahren nach einem der voranstehenden Ansprüche,
**dadurch gekennzeichnet, dass** mindestens eines der neuronalen Netze (10, 12-18) ein Ensemble (52) von mehreren neuronalen Unternetzen (54) umfasst, wobei
- von jedem neuronalen Unternetz (54) dieses Ensembles (52) jeweils ein Schaufelparameterwert (56) für denselben Schaufelparameter ermittelt wird und
- die von den neuronalen Unternetzen (54) des Ensembles (52) ermittelten Schaufelparameterwerte (56) gewichtet oder ungewichtet gemittelt werden, wobei der auf diese Weise erhaltene, gemittelte Schaufelparameterwert (58) von dem besagten neuronalen Netz (10, 12-18), dem das Ensemble (52) angehört, über dessen Ausgabeschicht (44) als Schaufelparameter ausgegeben wird.

8. Verfahren zum Herstellen einer Strömungsmaschinenschaufel (26), umfassend die Schritte:
- Entwerfen einer Strömungsmaschinenschaufel (26) gemäß einem Verfahren nach einem der voranstehenden Ansprüche, wobei Schaufelparameter (8) ermittelt werden,
- gegebenenfalls Abwandeln eines oder mehrerer der Schaufelparameter (8) unter Berücksichtigung mindestens eines Optimierungskriteriums,
- Herstellen der Strömungsmaschinenschaufel (26) entsprechend den ermittelten, gegebenenfalls abgewandelten Schaufelparametern (8).

9. Rechnereinheit (2, 60) zur Durchführung eines Verfahrens nach einem der Ansprüche 1 bis 7.

10. Maschinenlesbares Speichermedium mit einem Programmcode, durch welchen eine Rechnereinheit (2, 60) zur Ausführung eines Verfahrens nach einem der Ansprüche 1 bis 7 veranlasst wird, wenn der Programmcode von der Recheneinheit (2, 60) ausgeführt wird.

## Claims

1. A method for designing a turbomachine blade (26) performed by means of a computer unit, in which predetermined input parameters (6) are transmitted to a neural network system (4) and blade parameters (8) are determined and output by the neural network system (4) based on the transmitted input parameters (6), wherein the neural network system (4) has multiple separate neural networks (10, 12-18) with one output layer (44) each, each of which determines one or more of the blade parameter(s) (8) and outputs it/them via its output layer (44), wherein a first neural network and a second neural network belong to the separate neural networks (10, 12-18) of the neural network system (4) and the blade parameter(s) which is/are determined by the first neural network and output via its output layer (44) is/are different from the blade parameter(s) which is/are determined by the second neural network and output via its output layer (44), and wherein the respective neural network of the neural network system is trained using training data before determination of the blade parameters,
wherein the blade parameters (8) determined by the neural network system (4) comprise geometric blade parameters (20),
wherein the geometric blade parameters (20)
- comprise one or more curvature parameters (22) and one or more thickness parameters (24), wherein the curvature parameter(s) (22) is/are determined by a different neural network (10, 12-18) of the neural network system (4) and is/are output via its output layer (44) than the thickness parameter(s) (24)
and,
that the input parameters (6) transmitted to the neural network system (4) are two-dimensional parameters, wherein the input parameters (6) represent at least one Mach number distribution (*Ma*_{SS}, *Ma*_{PS}) and/or at least one pressure distribution.

2. The method according to claim 1,
**characterized in that** prior to determination of the blade parameters (8), the respective neural network (10, 12-18) of the neural network system (4) is trained using training data that are a false or true subset of a basic training data set, wherein it is checked whether the basic training data set contains redundant parameters, and the training data which are used for training the neural networks (10, 12-18) correspond to the basic training data set or, if the basic training data set contains redundant parameters, to the basic training data set adjusted for the redundant parameters.

3. The method according to claim 1 or 2,
**characterized in that** prior to determination of the blade parameters (8), the respective neural network (10, 12-18) of the neural network system (4) is trained using training data, wherein after training of the neural networks (10, 12-18) of the neural network system (4) and prior to determination of the blade parameters (8), one or more existing neuron connections (50) are removed in at least one of the neural networks (10, 12-18) by means of a pruning method.

4. The method according to any one of the preceding claims,
**characterised in that** the blade parameters (8) determined by the neural network system (4) comprise a blade efficiency (η) of the turbomachine blade (26) and/or a logarithmic decrement (Ξ) of the turbomachine blade (26).

5. The method according to any one of the preceding claims,
**characterised in that** a third neural network belongs to the separate neural networks (10, 12-18) of the neural network system (4), wherein the first neural network determines geometrical blade parameters (20) and outputs these via its output layer, the second neural network determines a blade efficiency (η) and outputs it via its output layer (44), and the third neural network determines a logarithmic decrement (Ξ) of the turbomachine blade (26) and outputs it via its output layer (44).

6. The method according to any one of the preceding claims,
**characterised in that** at least one of the neural networks (10, 12-18) has a plurality of intermediate layers (46, 48) in addition to its said output layer (44).

7. The method according to any one of the preceding claims,
**characterised in that** at least one of the neural networks (10, 12-18) comprises an ensemble (52) of multiple neural subnetworks (54), wherein
- every neural subnetwork (54) of this ensemble (52) determines one blade parameter value (56) each for the same blade parameter, and
- the blade parameter values (56) determined by the neural subnetworks (54) of the ensemble (52) are averaged weighted or unweighted, wherein the averaged blade parameter value (58) obtained in this manner by said neural network (10, 12-18) to which the ensemble (52) belongs is output as a blade parameter via its output layer (44).

8. A method for producing a turbomachine blade (26), comprising the steps:
- designing a turbomachine blade (26) according to a method according to any one of the preceding claims, wherein blade parameters (8) are determined,
- optionally modifying one or more of the blade parameters (8), taking into account at least one optimisation criterion,
- producing the turbomachine blade (26) in accordance with the determined, optionally modified blade parameters (8).

9. A computer unit (2, 60) for performing a method according to any one of claims 1 to 7.

10. A machine-readable storage medium with programme code which causes a computer unit (2, 60) to execute a method according to any one of claims 1 to 7 when the programme code is executed by the computer unit (2, 60).

## Revendications

1. Procédé mis en œuvre par une unité informatique pour concevoir une aube de turbomachine (26), dans lequel des paramètres d'entrée prédéfinis (6) sont transmis à un système de réseau neuronal (4) et des paramètres d'aube (8) sont déterminés et émis par le système de réseau neuronal (4) sur la base des paramètres d'entrée (6) transmis, dans lequel le système de réseau neuronal (4) présente plusieurs réseaux neuronaux séparés (10, 12-18) ayant chacun une couche de sortie (44), chacun d'eux déterminant un ou plusieurs des paramètres d'aube (8) et les émettant via sa couche de sortie (44), dans lequel les réseaux neuronaux séparés (10, 12-18) du système de réseau neuronal (4) comprennent un premier réseau neuronal ainsi qu'un deuxième réseau neuronal et les un ou plusieurs paramètres d'aube qui sont déterminés par le premier réseau neuronal et émis via sa couche de sortie (44) sont différents des un ou plusieurs paramètres d'aube qui sont déterminés par le deuxième réseau neuronal et émis via sa couche de sortie (44), et dans lequel le réseau neuronal respectif du système de réseau neuronal est entraîné avant la détermination des paramètres d'aube à l'aide de données d'entraînement,
dans lequel les paramètres d'aube (8) qui sont déterminés par le système de réseau neuronal (4) comprennent des paramètres d'aube géométriques (20),
dans lequel les paramètres d'aube géométriques (20)
- comprennent un ou plusieurs paramètres de courbure (22) ainsi qu'un ou plusieurs paramètres d'épaisseur (24), dans lequel les un ou plusieurs paramètres de courbure (22) sont déterminés et émis via leur couche de sortie (44) par un réseau neuronal (10, 12-18) du système de réseau neuronal (4) différent de celui ou de ceux qui déterminent et émettent les un ou plusieurs paramètres d'épaisseur (24) et,
et,
que les paramètres d'entrée (6) transmis au système de réseau neuronal (4) sont des paramètres bidimensionnels, dans lesquels les paramètres d'entrée (6) représentent au moins une distribution de nombre de Mach (*Ma*_{SS}, *Ma*_{PS}) et/ou au moins une distribution de pression.

2. Procédé selon la revendication 1,
**caractérisé en ce qu'**avant la détermination des paramètres d'aube (8), le réseau neuronal respectif (10, 12-18) du système de réseau neuronal (4) est entraîné à l'aide de données d'entraînement, lesquelles sont un sous-ensemble vrai ou faux d'une base de données d'entraînement de base, dans lequel il est vérifié si la base de données d'entraînement de base contient des paramètres redondants, et les données d'entraînement qui sont utilisées pour entraîner les réseaux neuronaux (10, 12-18) correspondent à la base de données d'entraînement de base ou, si la base de données d'entraînement de base contient des paramètres redondants, à la base de données d'entraînement de base épurée des paramètres redondants.

3. Procédé selon la revendication 1 ou 2,
**caractérisé en ce qu'**avant la détermination des paramètres d'aube (8), le réseau neuronal respectif (10, 12-18) du système de réseau neuronal (4) est entraîné à l'aide de données d'entraînement, dans lequel, après l'entraînement des réseaux neuronaux (10, 12-18) du système de réseau neuronal (4) et avant la détermination des paramètres d'aube (8), pour au moins un des réseaux neuronaux (10, 12-18), une ou plusieurs connexions neuronales (50) existantes sont retirées au moyen d'un procédé d'élagage.

4. Procédé selon l'une quelconque des revendications précédentes,
**caractérisé en ce que** les paramètres d'aube (8) qui sont déterminés par le système de réseau neuronal (4) comprennent un rendement d'aube (η) de l'aube de turbomachine (26) et/ou un décrément logarithmique (Ξ) de l'aube de turbomachine (26).

5. Procédé selon l'une quelconque des revendications précédentes,
**caractérisé en ce que** les réseaux neuronaux séparés (10, 12-18) du système de réseau neuronal (4) comprennent un troisième réseau neuronal, dans lequel des paramètres d'aube géométriques (20) sont déterminés et émis via sa couche de sortie par le premier réseau neuronal, un rendement d'aube (η) est déterminé et émis via sa couche de sortie (44) par le deuxième réseau neuronal, et un décrément logarithmique (Ξ) de l'aube de turbomachine (26) est déterminé et émis via sa couche de sortie (44) par le troisième réseau neuronal.

6. Procédé selon l'une quelconque des revendications précédentes,
**caractérisé en ce qu'**au moins un des réseaux neuronaux (10, 12-18) présente une pluralité de couches intermédiaires (46, 48) en plus de sa dite couche de sortie (44).

7. Procédé selon l'une quelconque des revendications précédentes,
**caractérisé en ce qu'**au moins un des réseaux neuronaux (10, 12-18) comprend un ensemble (52) de plusieurs sous-réseaux neuronaux (54), dans lequel
- par chaque sous-réseau neuronal (54) de cet ensemble (52) est déterminée respectivement une valeur de paramètre d'aube (56) pour le même paramètre d'aube et
- les valeurs de paramètre d'aube (56) déterminées par les sous-réseaux neuronaux (54) de l'ensemble (52) sont moyennées avec ou sans pondération, dans lequel la valeur de paramètre d'aube (58) moyennée obtenue de cette manière est émise comme paramètre d'aube par ledit réseau neuronal (10, 12-18) auquel l'ensemble (52) appartient, via sa couche de sortie (44).

8. Procédé de fabrication d'une aube de turbomachine (26), comprenant les étapes suivantes :
- la conception d'une aube de turbomachine (26) selon un procédé selon l'une quelconque des revendications précédentes, dans lequel les paramètres d'aube (8) sont déterminés,
- le cas échéant, la modification d'un ou de plusieurs des paramètres d'aube (8) en tenant compte d'au moins un critère d'optimisation,
- la fabrication de l'aube de turbomachine (26) conformément aux paramètres d'aube (8) déterminés, le cas échéant modifiés.

9. Unité informatique (2, 60) pour la mise en œuvre d'un procédé selon l'une quelconque des revendications 1 à 7.

10. Support de stockage lisible par machine avec un code de programme, par lequel une unité informatique (2, 60) est amenée à réaliser un procédé selon l'une quelconque des revendications 1 à 7, lorsque le code de programme est exécuté par l'unité informatique (2, 60).
